# FASCICULE DE BREVET EUROPEEN

(11) **EP 3 807 450 B1**
(45) Date de publication et mention de la délivrance du brevet: **07.06.2023**
(21) Numéro de dépôt: 19742447.6
(22) Date de dépôt: 17.06.2019
(51) Int. Cl.: C23C 28/04, C23C 14/06, C23C 14/32, C23C 14/35, C23C 16/26, C23C 16/50, C23C 14/02

(54) **PIÈCE REVÊTUE PAR UN REVÊTEMENT DE CARBONE AMORPHE NON-HYDROGÉNÉ SUR UNE SOUS-COUCHE COMPORTANT DU CHROME, DU CARBONE ET DU SILICIUM**
TEIL MIT EINER WASSERSTOFFFREIEN AMORPHEN KOHLENSTOFFBESCHICHTUNG AUF EINER UNTERSCHICHT AUS CHROM, KOHLENSTOFF UND SILIZIUM
PART COATED WITH A NON-HYDROGENATED AMORPHOUS CARBON COATING ON AN UNDERCOAT COMPRISING CHROMIUM, CARBON AND SILICON

(30) Priorité: 18.06.2018 FR 1855318
(43) Date de publication de la demande: 21.04.2021
(73) Titulaire: HYDROMECANIQUE ET FROTTEMENT, 42160 Andrézieux-Bouthéon (FR)
(72) Inventeur: BOMBILLON, Laurent, 42160 Andrézieux-Bouthéon (FR); PROST, Fabrice, 42000 SAINT-ETIENNE (FR)
(74) Mandataire: Santarelli
(86) Numéro de dépôt international: PCT/FR2019/051463
(87) Numéro de publication internationale: WO 2019/243721

(56) Documents cités:
- EP-A1- 2 103 711
- JP-A- 2001 269 938
- US-A1- 2017 122 249

## Description

La présente invention concerne une pièce revêtue comportant un substrat métallique revêtu d'une sous-couche et d'un revêtement de carbone amorphe non-hydrogéné, lequel est déposé sur la sous-couche comportant du chrome, du carbone et du silicium.

Les pièces, comportant un revêtement, considérées ici, sont par exemple des organes de frottements pour les secteurs de l'automobile, de l'aéronautique ou encore du spatial.

Dans le domaine automobile, il s'agit par exemple de pièces de distributions comme des linguets, des poussoirs, ou encore des cames pour réduire le frottement entre ces pièces. Il peut aussi s'agir d'axes de piston, pour en réduire l'usure et protéger les surfaces contre le grippage.

Un revêtement tel que décrit ici peut aussi s'appliquer aux composants comme les segments, les jupes de piston, les chemises.

Dans les exemples non limitatifs qui précédent les revêtements sont souvent amenés à fonctionner en milieu lubrifié.

Bien évidemment, les revêtements de carbone amorphe, hydrogénés ou non, ont des applications multiples qui ne se limitent pas aux composants pour l'automobile, l'aéronautique ou le spatial. Des éléments de guidage ou coulissant, comme par exemple sur des moules pour la plasturgie, peuvent aussi être revêtus par un tel revêtement pour en minimiser l'usure et le frottement sans lubrification.

Les revêtements de carbone amorphe sont souvent nommés « DLC » (pour « Diamond Like Carbon »). Ils désignent des matériaux carbonés généralement obtenus sous forme d'une couche mince et par des technologies de dépôt sous vide.

Ces revêtements peuvent par exemple être classés en deux familles : ceux comportant de l'hydrogène (H) et ceux sans hydrogène.

Parmi les revêtements avec hydrogène, des revêtements DLC qui possèdent un fort intérêt industriel sont :
- Les revêtements « a-C:H » (pour « carbone amorphe hydrogéné »). Ces revêtements sont généralement réalisés par dépôt chimique en phase vapeur assisté par plasma d'un précurseur gazeux carboné (lequel est par exemple de l'acétylène (C₂H₂)).

Parmi les revêtements sans hydrogène, des revêtements DLC qui possèdent un fort intérêt industriel sont :
- Les revêtements « a-C » (pour « carbone amorphe »), qui sont généralement réalisés par pulvérisation cathodique magnétron d'une cible de graphite.
- Et surtout, les revêtements « ta-C » (pour « carbone amorphe tétraédrique »), qui sont généralement réalisés par évaporation par arc d'une cible de graphite.

Les trois types de revêtement susmentionnés sont donc chacun obtenu par une technologie différente.

En outre, actuellement, pour chaque type de revêtement DLC tel que ceux susmentionnés (réalisés avec des technologies différentes, comme illustré ci-dessus), il est souvent nécessaire d'utiliser une sous-couche spécifique pour que le revêtement adhère sur un substrat donné.

Par exemple, dans les cas de revêtements de ta-C, l'adhérence est obtenue par bombardement, à très haute énergie en début de dépôt (c'est-à-dire de l'ordre de quelques kilo-électronvolts), d'ions carbone (C) sur un substrat (ceci est par exemple décrit dans le document : Tetrahedrally Bonded Amorphous Carbon Films I, Basics, Structure and Préparation, Bernd Schultrich, ^{©} Springer-Verlag GmbH Germany 2018 p.552).

Le substrat est optionnellement préalablement revêtu d'une couche mince de chrome métallique (Cr), parfois d'un flash de chrome (Cr), ce qui permet notamment de favoriser une bonne adhérence sur un substrat en acier. Cette couche de chrome est toutefois optionnelle et peut donc être absente.

Or, selon l'état de l'art, l'adhérence optimale est obtenue, en bombardant par des ions carbone (C), à haute énergie, des substrats relativement froids.

Cette condition est contraignante car les étapes initiales qui précèdent ce bombardement (dégazage des substrats et de la machine par chauffage, décapage ionique et dépôt d'un flash de Cr) conduisent à un échauffement des pièces et cet échauffement est néfaste pour l'adhérence de la couche de ta-C. Il est donc souhaitable de procéder au refroidissement des substrats avant de les bombarder par des ions carbone énergétiques. Or, le refroidissement de pièces (ici des substrats) sous vide est souvent peu efficace et prend beaucoup de temps pour obtenir une température souhaitée en vue d'une adhérence considérée acceptable, typiquement plusieurs heures.

Par ailleurs, comme mentionnés précédemment, l'adhérence est obtenue en bombardant, par des ions carbone de forte énergie, des substrats préalablement revêtus d'un flash de chrome ou non.

La haute tension nécessaire à l'accélération des ions provoque un risque accru de déclenchement de phénomènes d'arcs électriques sur les pièces, ou les porte-pièces (aussi appelés porte-substrats), qui peuvent conduire à la destruction des pièces ou à la perte de l'adhérence des pièces exposées à l'arc. En outre, si le générateur de polarisation des pièces détecte un arc et se coupe, le dépôt d'ions carbone se produit sans accélération ce qui nuit à l'adhérence du revêtement de carbone sur les substrats alors exposés au dépôt.

Un autre inconvénient de cette phase de bombardement à haute énergie par des ions carbone est l'échauffement des pièces à revêtir résultant du transfert d'énergie des ions à la pièce à revêtir. La combinaison de la forte densité d'ions carbone sur le substrat et de la haute énergie, induit une forte densité de puissance appliquée au substrat et donc à une augmentation rapide de sa température.

Outre que cette élévation de température peut être préjudiciable aux caractéristiques des composants mécaniques dont les températures de revenu sont basses, c'est à dire typiquement comprises entre 150°C et 220°C, elle est aussi critique pour les propriétés mécaniques du ta-C qui s'écroulent au-dessus d'une température de dépôt d'environ 200°C.

Les procédés habituels peuvent donc conduire à des risques de surchauffe des pièces.

Ainsi, la présente invention a pour but de résoudre au moins en partie les inconvénients précités.

En particulier, un objet de l'invention est de proposer une pièce, comportant un revêtement DLC non-hydrogéné, qui présente des propriétés mécaniques assez élevées et dont le revêtement DLC a une adhérence satisfaisante au substrat.

La présente invention a aussi pour but de proposer une pièce qui peut être obtenue sans étape de refroidissement avant dépôt en cas de revêtement ta-C par exemple, c'est-à-dire dont un procédé de dépôt pour obtenir une telle pièce permet de s'affranchir de l'étape de refroidissement, avant dépôt du revêtement de ta-C, et de l'utilisation du bombardement ionique à haute énergie actuellement utilisé pour faire adhérer le revêtement ta-C.

A cet effet, est proposée selon un premier aspect, une pièce comportant un substrat métallique, un revêtement de carbone amorphe non-hydrogéné, de type ta-C voire a-C, revêtant le substrat, et une sous-couche à base de chrome (Cr), de carbone (C) et de silicium (Si) disposée entre le substrat métallique et le revêtement de carbone amorphe et sur laquelle le revêtement de carbone amorphe est appliqué, caractérisée en ce que la sous-couche comporte les proportions atomiques suivantes à son interface avec le revêtement de carbone amorphe (c'est-à-dire à la surface de la sous-couche) :
- Un rapport entre une teneur en silicium et une teneur en chrome (Si/Cr) compris entre 0,35 et 0,60, et
- Un rapport entre une teneur en carbone et la teneur en silicium (C/Si) compris entre 2,5 et 3,5.

Une telle composition de sous-couche présente des teneurs qui sont par exemple mesurables par analyse EDX (Energy Dispersive X-Ray Spectrometry, ou analyse par dispersion en énergie des rayons X) dans un microscope électronique à balayage (MEB), ou par GDOES (Glow Discharge Optical Emission Spectroscopy).

Il est apparu qu'une telle sous-couche permet d'obtenir un résultat d'adhérence du revêtement noté HF1, stable au cours du temps.

De plus, il est apparu qu'une telle sous-couche permet de se dispenser d'une étape de refroidissement, au moins en cas de dépôt de ta-C, car, au contraire de l'état de l'art, il est possible de débuter le dépôt du revêtement de carbone à de très basses tension de polarisation comparativement aux centaines de volt selon l'état de l'art.

Il est aussi apparu qu'une telle sous-couche permet une transition des propriétés mécaniques entre un revêtement DLC du type ta-C ou a-C et un substrat métallique.

Au surplus, une telle sous-couche s'est aussi révélée particulièrement avantageuse pour un revêtement DLC de carbone amorphe hydrogéné, c'est-à-dire en particulier de type a-C:H.

Une telle sous-couche se présente alors comme une couche à gradient de composition à base de chrome (Cr), silicium (Si) et carbone (C) principalement.

La sous-couche s'enrichit progressivement (en partant du substrat et en direction du revêtement DLC) en silicium (Si) et en carbone (C), jusqu'à une composition permettant l'adhérence du revêtement, comme visée ci-dessus.

Dans un exemple particulier, le rapport entre la teneur en silicium et la teneur en chrome (Si/Cr) de la sous-couche au voisinage de l'interface avec le DLC est compris entre 0,38 et 0,60, voire entre 0,40 et 0,60.

Dans un exemple particulier, le rapport entre la teneur en carbone et la teneur en silicium (C/Si) de la sous-couche au voisinage de l'interface avec le DLC est compris entre 2,8 et 3,2, voire entre 2,9 et 3,1.

La sous-couche peut comporter éventuellement de l'azote (N). Ceci est particulièrement avantageux si la pièce comporte en outre une couche de nitrure de chrome, comme décrit ci-après.

Ainsi, dans un exemple de réalisation intéressant, la sous-couche comporte en outre des atomes d'azote (N), un rapport entre une teneur en azote et la teneur en chrome (N/Cr) étant inférieur à 0,70 au voisinage de l'interface avec le DLC, c'est-à-dire à l'interface entre la sous-couche et le revêtement de carbone amorphe.

Selon des exemples avantageux, le rapport entre la teneur en azote et la teneur en chrome (N/Cr) est compris entre 0,26 et 0,70, voire entre 0,29 et 0,67, voire entre 0,35 et 0,65, à l'interface entre la sous-couche et le revêtement de carbone amorphe.

Selon des exemples avantageux, le rapport entre la teneur en silicium et la teneur en chrome (Si/Cr) est compris entre 0,40 et 0,55, voire entre 0,45 et 0,55, à l'interface entre la sous-couche et le revêtement de carbone amorphe.

Dans un exemple privilégié, la sous-couche, avec ou sans azote, a une épaisseur de quelques dixièmes de micromètre ; de préférence une épaisseur égale ou inférieure à environ 1,1 µm, par exemple comprise entre environ 0,2 µm et 1,1 µm, de préférence comprise entre environ 0,3 µm et 0,6 µm.

En effet, en pratique, au-delà de 1,1 µm il se produit un développement colonnaire, néfaste pour la tenue de la sous-couche, et en-dessous de 0,2 µm, la sous-couche ne produit pas son effet de couche d'adaptation.

Le revêtement de carbone amorphe, a, par exemple, une épaisseur égale ou supérieure à environ 0,3 µm, voire à environ 0,5 µm, voire à environ 1 µm, voire à 1,5 µm.

Le revêtement de carbone amorphe a, par exemple, une épaisseur égale ou inférieure à environ 10 µm, voire à 8 µm, voire même à 3,5 µm.

Le revêtement de carbone amorphe a, par exemple, une épaisseur comprise entre environ 1,5 µm et environ 3,5 µm, mais peut atteindre 8 µm lorsqu'un tel revêtement est appliqué à un segment par exemple.

Le substrat métallique est par exemple en acier ou autres alliages métalliques.

Dans des exemples de réalisation intéressants, la pièce comporte en outre une couche à base de chrome, déposée sur le substrat et sur laquelle est formée la sous-couche.

La couche à base de chrome est par exemple une couche de chrome (Cr) et/ou une couche de nitrure de chrome, par exemple CrN ou Cr₂N, ou tout composé intermédiaire.

De préférence, la pièce comporte une couche de chrome (Cr), ou une couche de chrome (Cr) suivie d'une couche de nitrure de chrome (par exemple CrN ou Cr₂N, ou tout composé intermédiaire).

De préférence, la couche à base de chrome a une épaisseur de quelques dixièmes de micromètre, de préférence une épaisseur égale ou inférieure à environ 1 µm, voire 0,6 µm, par exemple comprise entre environ 0,1 µm et 0,5 µm, voire entre environ 0,3 µm et 0,5 µm.

Le tableau ci-dessous présente différents essais, numérotés 1 à 15. Les proportions atomiques, mesurées par EDX, sont celles de la sous-couche au voisinage de l'interface avec le revêtement (gardant à l'esprit que la sous-couche présente un gradient de composition, la composition visée est celle vers laquelle elle tend à l'interface avec le revêtement DLC).

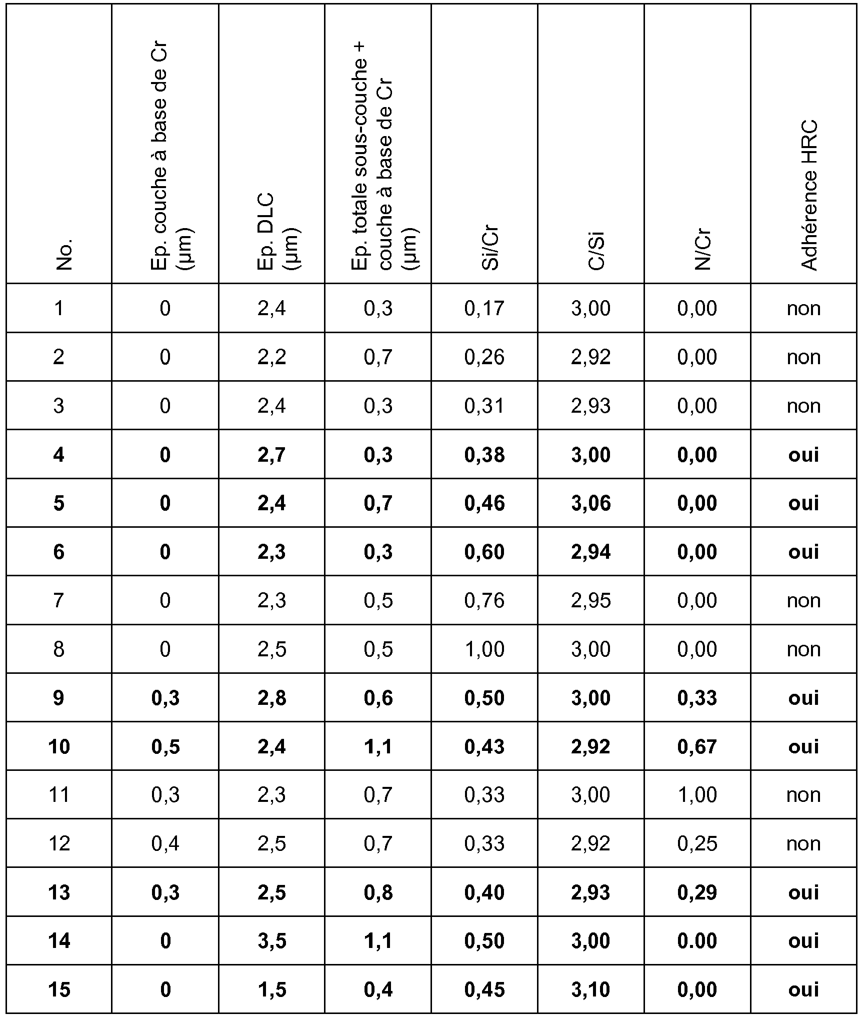

Dans l'ensemble des essais, on note que le comportement en adhérence du DLC sur la sous-couche est lié à la composition de la surface de la sous-couche.

La présence d'azote en surface n'est pas déterminante pour l'adhérence du DLC. En effet à proportions d'azote (N/Cr) similaires (exemples 9, 12 et 13), l'adhérence peut être jugée bonne ou non. Une présence relativement forte d'azote peut nuire à l'adhérence, comme dans l'exemple 11. L'absence d'azote peut conduire à des bonnes adhérences (exemples 4 à 6, 14 et 15) ou non (exemples 1 à 3, 7, 8).

En revanche, la proportion de chrome s'est révélée être un facteur plus déterminant. La proportion de chrome est définie par le rapport Si/Cr, et le rapport N/Cr s'il y a de l'azote. Une proportion relativement élevée en chrome ne semble pas convenir pour l'adhérence (ex. exemples 1 à 3). Une proportion de chrome relativement faible ne semble pas non plus convenir pour l'adhérence du DLC (ex. exemples 7 et 8).

Ainsi, alors que le rapport des compositions Si/Cr est compris entre 0,35 et 0,6, l'ensemble des couches de DLC déposées sur ces sous-couches s'est révélé adhérent (exemples 4, 5, 6, 9, 10, 13, 14 et 15).

Pour obtenir un revêtement tel que décrit précédemment, un équipement de dépôt sous vide tel que décrit ci-dessous est utilisé.

L'équipement de dépôt sous vide comporte principalement une enceinte, un système de pompage, un système de chauffage, configurés pour pomper, chauffer les pièces (substrat) et l'intérieur de l'enceinte, afin accélérer la désorption des gaz et obtenir rapidement un vide, considéré de qualité, dans l'enceinte.

L'équipement de dépôt comporte en outre un porte-substrat adapté, du point de vue de la géométrie, de la polarisation électrique et de la cinématique, aux pièces, ou à la portion des pièces à revêtir.

L'équipement de dépôt sous vide comporte aussi un système de décapage ionique configuré pour bombarder les pièces (substrats) à revêtir par des ions argon (Ar), afin d'éliminer une couche de passivation généralement présente sur les substrats métalliques à revêtir.

Dans le cadre d'un revêtement ta-C, de nombreuses technologies différentes de décapage ionique peuvent convenir. Il en va de même pour un revêtement d'a-C.

L'équipement de dépôt sous vide comporte aussi une cathode magnétron, équipée d'une cible de chrome, pour générer les couches à base de chrome.

De préférence, le système de décapage ionique est configuré pour fonctionner simultanément avec la cathode magnétron. On met ainsi à profit la fin du décapage ionique pour pré-pulvériser la cathode magnétron équipée d'une cible de chrome.

Un tel équipement est alors particulièrement intéressant car il permet de déposer également des revêtements de type a-C:H adéquats.

Par exemple, la source de plasma telle que celle décrite dans le document FR 2 995 493 peut être mise en oeuvre pour effectuer un décapage ionique efficace des pièces à revêtir et les revêtir d'un revêtement DLC de type ta-C, ou a-C, ou même a-C :H.

L'étape de dépôt de la sous-couche est par exemple configurée pour produire une sous-couche ayant une composition telle que décrite précédemment.

L'étape de dépôt de la sous-couche est par exemple configurée pour en outre produire une sous-couche ayant une épaisseur telle que décrite précédemment.

Dans un exemple de mise en oeuvre, le procédé peut optionnellement comporter une étape de dépôt de chrome métallique, par exemple une étape de pulvérisation de chrome.

Optionnellement, cette étape de dépôt de chrome métallique comporte une étape d'introduction d'azote simultanément avec l'étape de pulvérisation de chrome de sorte à obtenir une couche de nitrure de chrome, par exemple CrN ou Cr₂N ou tout composé intermédiaire.

Une telle couche à base de chrome, éventuellement avec de l'azote, est déposée avec une épaisseur de quelques dixièmes de micromètre, comme décrit précédemment.

Le dépôt se poursuit par l'introduction d'un gaz organosilicié, c'est-à-dire un gaz portant au moins du silicium, typiquement du tétraméthylsilane (aussi nommé TMS, de formule (Si(CH₃)₄), lequel peut comporter des traces d'oxygène) qui est le plus facile à mettre en oeuvre, ou un mélange de silane et d'un hydrocarbure. Sans être exclusif, le TMS est de loin utilisé de façon préférentielle pour sa relativement grande stabilité chimique et sa grande volatilité lui permettant une mise en oeuvre facile au moyen d'un débitmètre massique.

En cas de dépôt préalable d'une couche à base de chrome (Cr, et/ou CrN ou Cr₂N), le gaz organosilicié est introduit à débit croissant jusqu'à une valeur de débit auquel une teneur en silicium de la sous-couche est au moins égale à environ 0,35 fois sa teneur en chrome et au plus d'environ 0,60 fois la teneur en chrome au voisinage de l'interface. Le rapport de la teneur en carbone ramené à la teneur en silicium est parallèlement compris entre 2,5 et 3,5 au voisinage de l'interface.

Lorsqu'une couche à base de chrome avec de l'azote est utilisée, la quantité d'azote injectée peut être graduellement réduite quand la quantité de gaz organosilicié augmente. La quantité d'azote n'est pas nécessairement amenée à 0 mais doit devenir notablement inférieure à celle de gaz organosilicié. L'azote introduit pour produire une couche de CrN (ou Cr₂N) peut aussi être ramené abruptement à 0 avant d'introduire le précurseur organosilicié. Néanmoins la diminution progressive de l'azote est un mode préférentiel car il permet une transition progressive d'azote dans la sous-couche.

A titre d'exemple, considérant une couche de CrN, N/Cr vaut alors par exemple 1 et donc la quantité d'azote est possiblement considérée comme excessive. Considérant une couche de Cr₂N, N/Cr vaut alors par exemple 0,5 et dans un tel cas, ce ratio peut être conservé.

Pendant l'élaboration des diverses couches minces sous vide décrites précédemment (couche à base de chrome, sous-couche ou encore revêtement DLC), la tension de polarisation du porte-substrat se situe généralement entre -50 V et -100 V (volt).

La pression partielle d'argon pendant le dépôt de ces couches se situe de préférence entre 0,2 Pa et 0,4 Pa.

Lorsque le débit de gaz organosilicié a atteint le niveau requis, l'alimentation électrique de la cathode magnétron est coupée, les gaz réactifs (c'est-à-dire le gaz organosilicié, ou le gaz organosilicié et l'azote suivant le cas) sont arrêtés. Le débit d'argon, le cas échéant, est réduit à une valeur faible voire amené à 0, pour commencer le dépôt de ta-C à l'aide de sources d'arc, ou le dépôt d'a-C.

## Revendications

1. Pièce comportant un substrat métallique, un revêtement de carbone amorphe non-hydrogéné, de type ta-C voire a-C, revêtant le substrat, et une sous-couche à base de chrome (Cr), de carbone (C) et de silicium (Si) disposée entre le substrat métallique et le revêtement de carbone amorphe et sur laquelle le revêtement de carbone amorphe est appliqué, **caractérisée en ce que** la sous-couche comporte les proportions atomiques suivantes à son interface avec le revêtement de carbone amorphe :
- Un rapport entre une teneur en silicium et une teneur en chrome (Si/Cr) compris entre 0,35 et 0,60, et
- Un rapport entre une teneur en carbone et la teneur en silicium (C/Si) compris entre 2,5 et 3,5.

2. Pièce selon la revendication 1, **caractérisée en ce que** le rapport entre la teneur en silicium (Si) et la teneur en chrome (Cr) (Si/Cr) de la sous-couche est compris entre 0,38 et 0,6.

3. Pièce selon l'une quelconque des revendications 1 ou 2, **caractérisée en ce que** le rapport entre la teneur en carbone (C) et la teneur en silicium (Si) (C/Si) de la sous-couche est compris entre 2,8 et 3,2, voire entre 2,9 et 3,1.

4. Pièce selon l'une quelconque des revendications 1 à 3, **caractérisée en ce que** la sous-couche comporte en outre des atomes d'azote (N), un rapport entre une teneur en azote et la teneur en chrome (N/Cr) étant inférieur à 0,70 à l'interface entre la sous-couche et le revêtement de carbone amorphe.

5. Pièce selon la revendication 4, **caractérisée en ce que** le rapport entre la teneur en azote et la teneur en chrome (N/Cr) est compris entre 0,26 et 0,70 et le rapport entre la teneur en silicium et la teneur en chrome (Si/Cr) est compris entre 0,40 et 0,55 à l'interface entre la sous-couche et le revêtement de carbone amorphe.

6. Pièce selon l'une quelconque des revendications 1 à 5, **caractérisée en ce que** la sous-couche a une épaisseur égale ou inférieure à 1,1 µm, par exemple comprise entre 0,2 µm et 1,1 µm, de préférence comprise entre 0,3 µm et 0,6 µm.

7. Pièce selon l'une quelconque des revendications 1 à 6, **caractérisée en ce que** le revêtement de carbone amorphe a une épaisseur égale ou supérieure à 0,3 µm, voire à 0,5 µm, voire à 1 µm.

8. Pièce selon l'une quelconque des revendications 1 à 7, **caractérisée en ce que** le revêtement de carbone amorphe a une épaisseur comprise entre 1,5 µm et 3,5 µm.

9. Pièce selon l'une quelconque des revendications 1 à 8, **caractérisée en ce qu'**elle comporte en outre une couche à base de chrome, déposée sur le substrat et sur laquelle est formée la sous-couche, la couche à base de chrome étant une couche de chrome (Cr) et/ou une couche de nitrure de chrome, par exemple CrN ou Cr₂N, ou tout composé intermédiaire.

10. Pièce selon la revendication 9, **caractérisée en ce que** la couche à base de chrome a une épaisseur de quelques dixièmes de micromètre, de préférence une épaisseur égale ou inférieure à 1 µm, voire 0,6 µm, par exemple comprise entre 0,1 µm et 0,5 µm, voire entre 0,3 µm et 0,5 µm.

## Patentansprüche

1. Teil, das ein Metallsubstrat enthält, eine Beschichtung aus wasserstofffreiem amorphem Kohlenstoff vom Typ ta-C oder sogar a-C, die das Substrat beschichtet, und eine Unterschicht auf der Basis von Chrom (Cr), Kohlenstoff (C) und Silizium (Si), die zwischen dem Metallsubstrat und der Beschichtung aus amorphem Kohlenstoff angeordnet ist und auf die die Beschichtung aus amorphem Kohlenstoff aufgebracht ist, **dadurch gekennzeichnet, dass** die Unterschicht an ihrer Grenzfläche mit der Beschichtung aus amorphem Kohlenstoff die folgenden atomaren Proportionen enthält:
- ein Verhältnis von einem Siliziumgehalt zu einem Chromgehalt (Si/Cr) zwischen 0,35 und 0,60, und
- ein Verhältnis von einem Kohlenstoffgehalt zu einem Siliziumgehalt (C/Si) zwischen 2,5 und 3,5.

2. Teil nach Anspruch 1, **dadurch gekennzeichnet, dass** das Verhältnis des Siliziumgehalts (Si) zum Chromgehalt (Cr) (Si/Cr) der Unterschicht zwischen 0,38 und 0,6 liegt.

3. Teil nach einem der Ansprüche 1 oder 2, **dadurch gekennzeichnet, dass** das Verhältnis des Kohlenstoffgehalts (C) zum Siliziumgehalt (Si) (C/Si) der Unterschicht zwischen 2,8 und 3,2 liegt oder sogar zwischen 2,9 und 3,1.

4. Teil nach einem der Ansprüche 1 bis 3, **dadurch gekennzeichnet, dass** die Unterschicht ferner Stickstoffatome (N) enthält, wobei ein Verhältnis von einem Stickstoffgehalt zum Chromgehalt (N/Cr) kleiner als 0,70 ist an der Grenzfläche zwischen der Unterschicht und der Beschichtung aus amorphem Kohlenstoff.

5. Teil nach Anspruch 4, **dadurch gekennzeichnet, dass** das Verhältnis des Stickstoffgehalts zum Chromgehalt (N/Cr) zwischen 0,26 und 0,70 liegt und das Verhältnis des Siliziumgehalts zum Chromgehalt (Si/Cr) zwischen 0,40 und 0,55 liegt an der Grenzfläche zwischen der Unterschicht und der Beschichtung aus amorphem Kohlenstoff.

6. Teil nach einem der Ansprüche 1 bis 5, **dadurch gekennzeichnet, dass** die Unterschicht eine Dicke von 1,1 um oder weniger aufweist, beispielsweise zwischen 0,2 µm und 1,1 um, vorzugsweise zwischen 0,3 µm und 0,6 µm.

7. Teil nach einem der Ansprüche 1 bis 6, **dadurch gekennzeichnet, dass** der amorphe Kohlenstoff eine Dicke von 0,3 µm oder größer aufweist oder sogar 0,5 µm oder sogar 1 µm.

8. Teil nach einem der Ansprüche 1 bis 7, **dadurch gekennzeichnet, dass** die Beschichtung aus amorphem Kohlenstoff eine Dicke zwischen 1,5 µm und 3,5 µm aufweist.

9. Teil nach einem der Ansprüche 1 bis 8, **dadurch gekennzeichnet, dass** es ferner eine Schicht auf der Basis von Chrom enthält, die auf dem Substrat abgeschieden ist, und auf der die Unterschicht gebildet ist, wobei die Schicht auf der Basis von Chrom eine Chromschicht (Cr) und/oder eine Chromnitridschicht ist, beispielsweise CrN oder Cr₂N, oder eine beliebige Zwischenverbindung.

10. Teil nach Anspruch 9, **dadurch gekennzeichnet, dass** die Schicht auf Basis von Chrom eine Dicke von einigen Zehntelmikrometern aufweist, vorzugsweise eine Dicke von 1 um oder weniger oder sogar 0,6 um, beispielsweise zwischen 0,1 µm und 0,5 µm oder sogar zwischen 0,3 µm und 0,5 µm.

## Claims

1. Part comprising a metal substrate, a non-hydrogenated amorphous carbon coating, of ta-C type or even of a-C type, coating the substrate, and a sub-layer based on chromium (Cr), carbon (C) and silicon (Si) disposed between the metal substrate and the amorphous carbon coating and on which the amorphous carbon coating is applied, **characterized in that** the sub-layer comprises the following atomic ratios at its interface with the amorphous carbon coating:
- A ratio between the silicon content and the chromium content (Si/Cr) comprised between 0.35 and 0.60, and
- A ratio between the carbon content and the silicon content (Si/Cr) comprised between 2.5 and 3.5.

2. Part according to claim 1, **characterized in that** the ratio between the silicon content (Si) and the chromium content (Cr) (Si/Cr) of the sub-layer is comprised between 0.38 and 0.6.

3. Part according to any one of claims 1 or 2, **characterized in that** the ratio between the carbon content (C) and the silicon content (Si) (Si/Cr) of the sub-layer is comprised between 2.8 and 3.2, or even between 2.9 and 3.1.

4. Part according to any one of claims 1 to 3, **characterized in that** the sub-layer further comprises atoms of nitrogen (N), a ratio between the nitrogen content and the chromium content (N/Cr) being less than 0.70 at the interface between the sub-layer and the amorphous carbon coating.

5. Part according to claim 4, **characterized in that** the ratio between the nitrogen content and the chromium content (N/Cr) is comprised between 0.26 and 0.70 and the ratio between the silicon content and the chromium content (Si/Cr) is comprised between 0.40 and 0.55 at the interface between the sub-layer and the amorphous carbon coating.

6. Part according to any one of claims 1 to 5, **characterized in that** the sub-layer has a thickness equal to or less than 1.1 µm, for example comprised between 0.2 µm and 1.1 µm, preferably comprised between 0.3 µm and 0.6 µm.

7. Part according to any one of claims 1 to 6, **characterized in that** the amorphous carbon coating has a thickness equal to or greater than 0.3 µm, or even than 0.5 µm, or possibly even than 1 µm.

8. Part according to any one of claims 1 to 7, **characterized in that** the amorphous carbon coating has a thickness comprised between 1.5 µm and 3.5 µm.

9. Part according to any one of claims 1 to 8, **characterized in that** it further comprises a chromium-based layer, deposited on the substrate and on which the sub-layer is formed, the chromium-based layer being a layer of chromium (Cr) and/or a layer of chromium nitride, for example CrN or Cr₂N, or any intermediate compound.

10. Part according to claim 9, **characterized in that** the chromium-based layer has a thickness of a few tenths of a micrometer, preferably a thickness equal to or less than 1 µm, or even 0.6 µm, for example comprised between 0.1 µm and 0.5 µm, or even between 0.3 µm and 0.5 µm.
